# EUROPEAN PATENT APPLICATION

(11) **EP 4 783 787 A1**
(43) Date of publication of application: **29.07.2026**
(21) Application number: 25878434.7
(22) Date of filing: 30.09.2025
(51) Int. Cl.: H10F 77/30

(54) **BACK CONTACT CELL AND MODULE**

(30) Priority: 31.10.2024 CN 202422659489 U
(71) Applicant: Zhejiang Aiko Solar Energy Technology Co., Ltd., Jinhua, Zhejiang 322009 (CN)
(72) Inventor: LIU, Haichao, Jinhua, Zhejiang 322009 (CN); LIU, Shengpu, Jinhua, Zhejiang 322009 (CN); SUN, Qinkang, Jinhua, Zhejiang 322009 (CN); YANG, Xinqiang, Jinhua, Zhejiang 322009 (CN)
(74) Representative: EP&C
(86) International application number: PCT/CN2025/126105
(87) International publication number: WO 2026/092057

(57) **Abstract**

The present disclosure is applicable to the technical field of photovoltaics and provides a back-contact solar cell and module. A plurality of grooves are formed in a back side of a silicon wafer. The silicon wafer has a first extension portion in a first region that extends and protrudes to a position above the groove. A second polarity doped layer is positioned on a second tunnelling layer and has a preset distance from an edge of the groove. The second polarity doped layer has a second extension portion extending towards a direction of the groove.

## Description

### Cross Reference to Related Applications

The present disclosure claims the priority of Chinese patent application entitled "Back-Contact Cell Piece, Cell Module and Photovoltaic System" submitted on October 31, 2024, with the application number of 202422659489.5, which is incorporated herein by reference in its entirety.

### Technical Field

The present disclosure belongs to the technical field of photovoltaics, and particularly relates to a back-contact cell piece and module.

### Background

A back-contact cell piece is a cell in which both emitter and base contact electrodes are placed on a back side (non-light-receiving side) of the cell. A light-receiving side of the cell is not shaded by any metal electrode, thereby effectively increasing the efficiency of the cell piece.

In the related art, in order to solve the surface passivation problem in a grooved region on the back side of the back-contact cell and reduce hydrogen-related defects in a bulk region, a passivation contact region requires hydrogen to passivate defect states in a tunnelling layer, which necessitates the use of a high-refractive-index passivation coating (such as high-refractive-index SiNx) to achieve better content of mobile hydrogen. However, excessive hydrogen entering a substrate region may lead to the attenuation of the cell. Meanwhile, the passivation coating (such as AlOx) in the grooved region tends to field passivation with negative charges. Such a configuration induces a p+ layer on a surface, and a space charge region is generated at an interface between the p+ layer and an n++ layer. Recombination at this region will increase junction recombination current of the cell, significantly degrading the performance of the cell.

### Summary

The present disclosure provides a back-contact cell piece and module, aiming to solve the technical problems of significant degradation and reduced performance of the back-contact cell piece in the related art.

The present disclosure is achieved in such a way of providing a back-contact solar cell including:
a silicon substrate having a rear side and a light-receiving surface arranged opposite to the rear side, wherein first regions and second regions are alternatively arranged on the rear side of the silicon substrate, and a groove is disposed between a first region and a second region adjacent to the first region;
a first tunnelling layer stacked on and covering the first region;
a first polarity doped layer stacked on the first tunnelling layer and having a first extension portion extending toward the groove;
a second tunnelling layer stacked on the second region;
a second polarity doped layer stacked on the second tunnelling layer, wherein a side surface of the second polarity doped layer is spaced apart from a side wall of the groove by a first distance, a second extension portion extends from one side of the second polarity doped layer away from the silicon substrate toward the groove; and
a passivation coating covering the first polarity doped layer, the second polarity doped layer and the groove.

In some implementations, the second extension portion does not extend to a position above the groove.

In some implementations, the passivation coating enwraps the second extension portion.

In some implementations, a side wall of the second tunnelling layer is flush with a side wall of the second polarity doped layer connected to the second tunnelling layer, the passivation coating covers the silicon substrate, the passivation coating covering a bottom surface of the second extension portion is spaced apart from the passivation coating covering the silicon substrate by a second distance, and the second distance is less than 150nm.

In some implementations, along an arrangement direction of the first regions and the second regions, a length of the first extension portion is greater than a length of the second extension portion.

In some implementations, along the arrangement direction of the first regions and the second regions, the length of the first extension portion ranges from 0.5µm to 3µm.

In some implementations, along the arrangement direction of the first regions and the second regions, the length of the second extension portion is less than or equal to 200nm.

In some implementations, surfaces of the second regions are flush with surfaces of the first regions.

In some implementations, a distance between the surfaces of the second regions and a bottom of the groove is less than a distance between the surfaces of the first regions and the bottom of the groove.

In some implementations, a side surface of the groove is an inclined surface.

In some implementations, a surface of the second extension portion facing the groove has a concave-convex structure.

In some implementations, a roughness of a bottom surface of the groove is greater than a roughness of the side surface of the groove, and the roughness of the side surface of the groove is greater than a roughness of surfaces of first extension portion and second extension portion away surface of the groove.

In some implementations, a width of the groove ranges from 2µm to 200µm.

In some implementations, a recess depth of the groove ranges from 0.2µm to 10µm.

The present disclosure further provides a cell module including the back-contact solar cell.

The present disclosure further provide a photovoltaic system including the cell module.

The present disclosure has the following beneficial effects. Providing the first extension portion extending to the position above the groove creates, at the groove, a recess region which is narrower at an opening and wider internally, such that the exchange of plasma with an external environment in a deposition process of the passivation coating may be decreased, thereby enabling a localized distribution of the content of mobile hydrogen in the passivation coating to achieve optimal passivation and anti-degradation effects. Further, providing the second extension portion enables the passivation coating to cover an underlying structure more evenly and completely, such that the contact area between the passivation coating and the underlying structure is increased and the passivation effect is enhanced. The enhanced passivation effect is conducive to the reduction of leakage currents, resulting in a significant contribution to long-term performance stability and increased efficiency of the cell. Furthermore, providing the first extension portion and the second extension portion may increase the reflection of incident light entering the silicon substrate and increase the efficiency of the cell.

### Brief Description of Drawings

Fig. 1 is a schematic cross-sectional structural view of a back-contact cell piece according to an embodiment of the present application;
Fig. 2 is another schematic cross-sectional structural view of a back-contact cell piece according to an embodiment of the present application;
Fig. 3 is further schematic cross-sectional structural view of a back-contact cell piece according to an embodiment of the present application;
Fig. 4 is further schematic cross-sectional structural view of a back-contact cell piece according to an embodiment of the present application; and

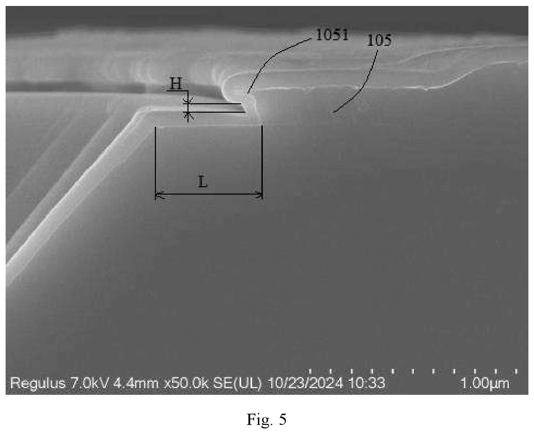

Fig. 5 is a view of a physical image of a back-contact cell according to an embodiment of the present application.

### Description of reference symbols:

100, back-contact solar cell; 101, silicon substrate; 1011, third extension portion; 110, first region; 120, second region; 130, groove; 102, first tunnelling layer; 103, first polarity doped layer; 1031, first extension portion; 104, second tunnelling layer; 105, second polarity doped layer; 1051, second extension portion; 106, passivation coating; 107, first electrode; and 108, second electrode.

### Detailed Description of Embodiments

In order to make objectives, technical solutions and advantages of the present disclosure clearer, the present disclosure will be further described in detail below with reference to accompanying drawings and embodiments. Examples of the embodiments described herein are shown in accompanying drawings, in which the same or similar reference symbols denote the same or similar elements or elements having the same or similar functions throughout. Embodiments described below with reference to the accompanying drawings are exemplary, are provided merely for the purpose of illustrating the present disclosure, and should not be construed as a limitation to the present disclosure. Further, it should be understood that specific embodiments described herein are merely used for describing the present disclosure rather than limiting the present disclosure.

In the description of the present disclosure, it should be understood that orientational or positional relationships indicated by terms such as "length", "width", "upper", "lower", "left", "right", "horizontal", "top" and "bottom" are based on orientational or positional relationships shown in the accompanying drawings, are only for the purpose of facilitating the description of the present disclosure and simplifying the description, but are not intended to indicate or imply that a device or component referred to must have a particular orientation or be constructed and operated in a particular orientation. Therefore, such terms should not be construed as a limitation to the present disclosure.

In addition, terms "first" and "second" are used for a descriptive purpose only and should not be construed as indicating or implying relative importance or implying a quantity of technical features indicated. Thereby, a feature defined by "first" or "second" may explicitly or implicitly include one or more of such features. In the description of the present disclosure, "a plurality of" means two or more, unless otherwise explicitly and particularly defined.

In the description of the present disclosure, it should be noted that, unless otherwise explicitly specified or defined, terms such as "install", "connect" and "connection" shall be construed broadly. For example, they may be a fixed connection, a detachable connection, or an integral connection; they may be a mechanical connection, an electrical connection or a mutual communication; and they may be a direct connection or an indirect connection via an intermediate medium, and they may be an internal communication between two components or an interaction relationship between the two components. Specific meanings of the above terms in the present disclosure may be understood depending on specific circumstances for those ordinarily skilled in the art.

In the present disclosure, unless otherwise expressly specified or defined, a first feature being "on" or "under" a second feature may involve the first feature being in contact with the second feature, or the first feature is not in direct contact with the second feature but rather is in contact with the second feature through a further feature therebetween. Moreover, the first feature being "on", "above", and "over" the second feature involves the first feature being directly above and obliquely above the second feature, or simply indicates that the first feature is horizontally higher than the second feature. The first feature being "under", "below" and "underneath" the second feature involves the first feature being directly below and obliquely below the second feature, or simply indicates that the first feature is horizontally lower than the second feature.

The description below provides a number of different embodiments or examples to implement different structures of the present disclosure. In order to simplify the description of the present disclosure, parts and settings of specific examples will be described below. Definitely, they are only examples and are not intended to limit the present disclosure. In addition, reference numbers and/or reference letters may be repeated in different examples of the present disclosure, and such a repetition is for the purposes of simplification and clarity and does not in itself indicate the relationship between various embodiments and/or settings in question. Further, although the present disclosure provides examples of various specific processes and materials, applications of further processes and/or use of further materials may occur in those ordinarily skilled in the art.

In the present disclosure, providing the first extension portion extending to the position above the groove creates, at the groove, a recess region which is narrower at an opening and wider internally, such that the exchange of plasma with an external environment in a deposition process of the passivation coating may be decreased, thereby enabling a localized distribution of the content of mobile hydrogen in the passivation coating to achieve optimal passivation and anti-degradation effects. Further, providing the second extension portion enables the passivation coating to cover an underlying structure more evenly and completely, such that the contact area between the passivation coating and the underlying structure is increased and the passivation effect is enhanced. The enhanced passivation effect is conducive to the reduction of leakage currents, resulting in a significant contribution to long-term performance stability and increased efficiency of the cell. Furthermore, providing the first extension portion and the second extension portion may increase the reflection of incident light entering the silicon substrate and increase the efficiency of the cell.

### Embodiment I

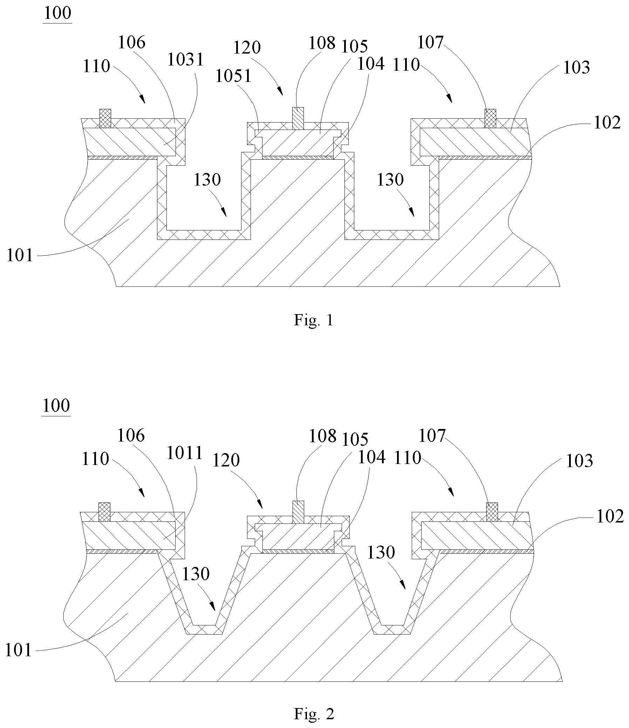

As shown in Fig. 1 and Fig, 5, an embodiment of the present disclosure provides a back-contact solar cell 100, including:
a silicon substrate 101 having a rear side and a light-receiving surface which are arranged opposite to each other, wherein first regions 110 and second regions 120 are alternatively arranged on the rear side of the silicon substrate 101, and a groove 130 is disposed between the first region 110 and the second region 120 which are adjacent;
a first tunnelling layer 101 stacked on and covering the first region 110;
a first polarity doped layer 103 stacked on the first tunnelling layer 102 and having a first extension portion 1031 extending toward the groove 130;
a second tunnelling layer 104 stacked on the second region 120;
a second polarity doped layer 105 stacked on the second tunnelling layer 104, wherein a side surface of the second polarity doped layer 105 is spaced apart from a side wall of the groove 130 by a first distance, a second extension portion 1051 extends from one side of the second polarity doped layer 105 away from the silicon substrate 101 toward the groove 130; and
a passivation coating 106 covering the first polarity doped layer 103, the second polarity doped layer 105 and the groove 130.

The silicon substrate 101 has two main surfaces: the light-receiving surface and the rear side. The light-receiving surface is directly exposed to sunlight, while the rear side is on the other side. The two surfaces are arranged opposite each other.

Two different regions are arranged on the rear side of the silicon substrate 101: the first region 110 and the second region 110 which are alternately arranged. Particularly, a plurality of first regions 110 and a plurality of second regions 120 are arranged alternately along a first direction, and both the first regions 110 and the second regions 120 extend along a second direction, with the second direction intersecting with the first direction. The first regions 110 and the second regions 120 can be alternately arranged along a transverse direction of the silicon substrate 101 and extend along a longitudinal direction, that is, the first direction can be the transverse direction of a back-contact cell and the second direction can be the longitudinal direction of the back-contact cell, with both perpendicular to each other. Definitely, in further embodiments, the first direction and the second direction can be further directions, for example, they can be diagonal directions of the silicon substrate 101, which is not particularly limited here.

A groove 130 is provided between the first region 110 and the second region 120 which are adjacent. The groove 130 extends along the second direction. An extending direction of the groove 130 is consistent with an extending direction of the first region 110 and the second region 120. The groove 130 separates the first region 110 from the second region 120 adjacent to the first region 110.

The first tunnelling layer 102 and the first polarity doped layer 103 are sequentially stacked within the first region 110. The first extension portion 1031 of the first polarity doped layer 103 extends from a position within the first region 110 to a position above the groove 130, and a projection of the first extension portion 1031 falls into the groove 130. The second tunnelling layer 104 and the second polarity doped layer 105 are sequentially stacked within the second region 120. The second polarity doped layer 105 is not a side wall of the second extension portion 1051 and has a preset distance L from an edge of the groove 130, that is, a platform region is disposed between the second polarity doped layer 105 and the groove 130. In this way, the formed platform region can increase the content of the movable hydrogen in the local passivation coating 106 above a space charge region, thereby enhancing hydrogen passivation in this region, reducing the recombination of the space charge region and improving the performance of the cell.

A second extension portion 1051 extends from one side of the second polarity doped layer 105 away from the silicon substrate 101 towards the groove, and the second extension portion 1051 protrudes from the side wall of the second polarity doped layer 105. The first polarity doped layer 103 and the second polarity doped layer 105 form regions with different electrical properties, supporting the formation of a PN junction and the separation of charge carriers.

A passivation coating 106 can cover the rear side of the entire silicon substrate 101, that is, the passivation coating may cover the first polarity doped layer 103, the second polarity doped layer 105, the side wall of the first tunnelling layer 102, the side wall of the second tunnelling layer 104 and the groove 130.

Providing the first extension portion 1031 obstructing an opening of the groove 130 creates, at the groove 130, a recess region which is narrower at an opening and wider internally, such that the exchange of plasma with an external environment in a deposition process of the passivation coating 106 (for example, the SiNx coating) may be decreased, thereby enabling a localized distribution of the content of mobile hydrogen in the passivation coating 106 to achieve optimal passivation and anti-degradation effects. Further, providing the second extension portion 1031 and the second extension portion 1051 enables the passivation coating 106 to cover an underlying structure (the silicon substrate 101, the first tunnelling layer 102 and the second tunnelling layer 104 which are disposed on the silicon substrate 101, and corresponding doped layers) more evenly and completely. The first extension portion 1031 and the second extension portion 1051 and the groove 130 are included, such that the contact area between the passivation coating 106 and the underlying structure is increased and the passivation effect is enhanced. The enhanced passivation effect is conducive to the reduction of leakage currents, resulting in a significant contribution to long-term performance stability and increased efficiency of the cell. Furthermore, providing the first extension portion 1031 and the second extension portion 1051 may increase the reflection of incident light entering the silicon substrate and increase the efficiency of the cell.

Particularly, the silicon substrate 101 can be a monocrystalline silicon substrate 101 or a polycrystalline silicon substrate 101, which can be a P-type silicon substrate or an N-type silicon substrate, and is not particularly limited here. The groove 130 on the silicon substrate 101 can be formed by a combination of grooving and etching. For example, a small opening can be formed on the silicon substrate 101 first, and then the opening can be etched by acid etching or alkali etching to form the final groove 130.

In some embodiments, the passivation coating 106 may include an aluminum oxide layer and a silicon nitride layer which are stacked. Definitely, the passivation coating 106 may further include one or more combinations of a silicon oxynitride layer, an intrinsic silicon carbide layer, an intrinsic amorphous silicon layer and a silicon oxide layer, which are not limited here.

It should be understood that the first polarity doped layer 103 can be one of a P-type doped layer and an N-type doped layer, and the second polarity doped layer 105 can be the other one of the P-type doped layer and the N-type doped layer. For example, in some embodiments, the first polarity doped layer 103 can be a P-type doped layer, and the second polarity doped layer 105 may be an N-type doped layer. The first tunnelling layer 102 and the second tunnelling layer 104 may be one or more combinations of a tunnelling oxide layer (such as a tunnelling silicon oxide layer), an intrinsic silicon carbide layer and an intrinsic amorphous silicon layer, which are not limited here.

Further, the back-contact solar cell 100 further has a first electrode 107 and a second electrode 108. The first electrode 107 can be disposed in the first region 110 and penetrates the passivation coating 106 to make ohmic contact with the first polarity doped layer 103. The second electrode 108 can be disposed in the second region 120 and penetrates the passivation coating 106 to make ohmic contact with the second polarity doped layer 105. Both the first electrode 107 and the second electrode 108 can be metal electrodes.

Particularly, the rear side of the silicon substrate 101 may include a polished surface or a textured surface, and the textured surface may be a surface with higher roughness such as suede. Further, in some embodiments, a region of the second region 120, which is covered by the second polarity doped layer 105, may be a polished surface, and a region of the second region 120, which is not covered by the second polarity doped layer 105, may be a textured surface. Definitely, the region of the second region 120, which is not covered by the second polarity doped layer 105, may be the polished surface, that is, the surface of the silicon wafer, which is positioned between the second polarity doped layer 105 and the edge of the groove 130, is the polished surface.

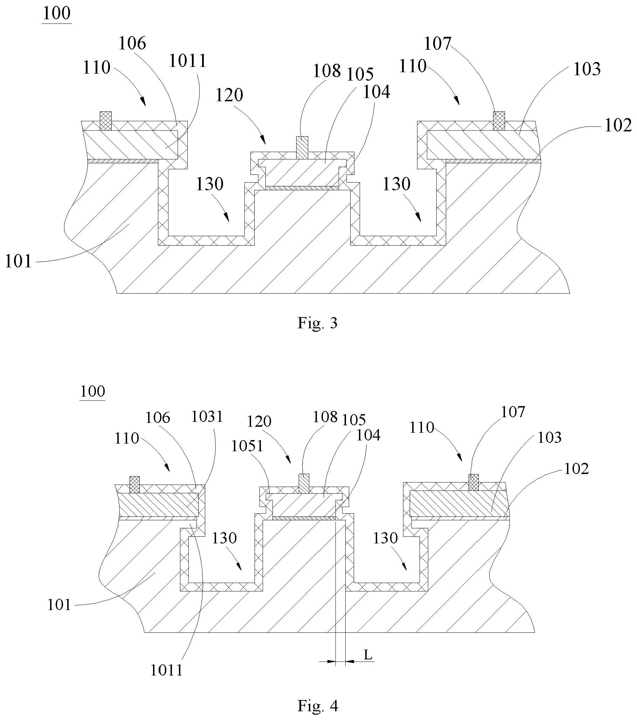

In some embodiments, as shown in Fig. 4, the silicon substrate 101 may further have a third extension portion 1011 extending and protruding to a position above the groove 130 at a junction of the first region 110 and the edge of the groove 130, and a projection of the portion extending and protruding to the position above the groove 130 falls into the groove 130. The first tunnelling layer 102 is stacked on the first region 110 and the third extension portion 1011, and the first polarity doped layer 103 and the first extension portion 1031 are stacked on the first tunnelling layer 102.

In some embodiments, the first extension portion 1031 has a portion extending and protruding further toward the position above the groove 130 than the third extension portion 1011.

### Embodiment II

On the basis of the above-mentioned embodiment I, the second extension portion 1051 does not extend to the position above the groove 130.

As such, a projection of the second extension portion 1051 cannot fall into the groove 130. Functional independence of the first region 110 and the second region 120 can be maintained, unnecessary interference between different doped regions can be avoided, and an electric field shielding effect inside the cell piece can be reduced. Such a layout helps the carrier charges transport from the silicon substrate to the electrodes more efficiently to maximize the current collection efficiency.

### Embodiment III

As shown in Fig. 1, on the basis of the above-mentioned embodiment I, the passivation coating 106 enwraps the second extension portion 1051.

Enwrapping with the passivation coating 106 can reduce the recombination of the carrier charges on the surface of the second extension portion 1051 and further reduce the recombination of electrons due to surface defects, thereby improving the performance of the cell. Exemplarily, the passivation coating 106 can provide an environment of chemical passivation and electric field passivation, which can effectively reduce the surface recombination speed.

In some implementations, the side wall of the second tunnelling layer 104 is flush with a side wall of the second polarity doped layer 105 connected to the second tunnelling layer 104, the passivation coating 106 covers the silicon substrate 101, the passivation coating 106 covering a bottom surface of the second extension portion 1051 is spaced apart from the passivation coating 106 covering the silicon substrate 101 by a second distance H, and the second distance is less than 150nm.

The side wall of the second tunnelling layer 104 is flush with the side wall of the second polarity doped layer 105 (the side wall of the second polarity doped layer 105 rather than the second extension portion 1051) connected to the second tunnelling layer 104, which is beneficial to reducing the impact of irregular structures on the transport of the carrier charges, ensuring that electric currents can be transported on a relatively smooth path, and improving the electrical performance and efficiency of a device. Since the side surface of the second polarity doped layer 105 is spaced apart from the side wall of the groove 130 by the first distance, that is, a partially exposed silicon substrate 101 exists, the passivation coating 106 covers the exposed silicon substrate 101.

A bottom surface of the second extension portion 1051 refers to a surface of the second extension portion 1051 facing the silicon substrate 101. The passivation coating covering a bottom surface of the second extension portion 1051 is spaced apart from the passivation coating 106 covering the silicon substrate 101 by a second distance, and the second distance is less than 150nm. Such a tight gap control may ensure minimal exposed region, maximal passivation and reduced unnecessary surface recombination.

### Embodiment IV

On the basis of the above-mentioned embodiment I, along an arrangement direction of the first regions 110 and the second regions 120, a length of the first extension portion 1031 is greater than a length of the second extension portion 1051.

In a direction from the first region 110 to the second region 120, a length of the first extension portion 1031 positioned on two sides of the same groove 130 is greater than a length of the second extension portion 1051. Such an asymmetric design is optimized for a charge separation and collection process. A longer extension portion means a larger contact area in the corresponding region, which can effectively promote the charge collection. A longer first extension portion 1031 corresponds to a region where minority carrier charges (such as electrons or holes) are concentrated. By increasing the contact area of this portion, a path for the carrier charge to transport from the silicon substrate 101 to an external circuit becomes more efficient, reducing the resistive loss.

Asymmetric extension portions also help optimize potential gradients, and facilitates charges to flow more efficiently from one side to the other side by adjusting potential differences in different regions. Such a structural design can improve the response capability of different regions to light, thereby ensuring the matching property of electric currents from the individual portions in the overall circuit to achieve higher conversion efficiency.

### Embodiment V

On the basis of the above-mentioned embodiment I, along an arrangement direction of the first regions 110 and the second regions 120, a length of the first extension portion 1031 ranges from 0.5µm to 3µm.

As such, controlling the length of the first extension portion 1031 within such a reasonable range can avoid the following issues: the length of the first extension portion 1031 is too small to effectively reduce the exchange of the plasma with the external environment in the deposition process of the passivation coating 106; the length of the extension portion is too large, which would result in an excessively small the opening of the groove 130 and increased difficulty of the etching process; and the length of the extension portion is too long, which may make the extension portion prone to breakage.

Particularly, in such embodiments, the length of the extension portion may be 0.2 µm, 0.3 µm, 0.4µm, 0.5µm, 0.6µm, 0.7µm, 0.8µm, 0.9µm, 1µm, 1.5µm, 2µm, 2.5µm, 3µm or any value between 0.2µm and 50µm.

### Embodiment VI

On the basis of the above-mentioned embodiment I, along an arrangement direction of the first regions 110 and the second regions 120, a length of the second extension portion 1051 is less than or equal to 200nm.

As such, setting the length of the second extension portion 1051 within such a reasonable range can prevent an excessively long second extension portion 1051 from increasing the resistance in the path, thereby reducing the overall conductivity and efficiency of equipment.

Particularly, in such embodiments, the length of the extension portion may be 200nm, 190nm, 180nm, 170nm, 160nm, 150nm, 140nm, 130nm, 120nm, 110nm, 100nm, 90nm, 80nm, 70nm, 60nm, 50nm, 40nm, 30nm, 20nm, 10nm or any value between 0nm and 200nm.

### Embodiment VII

As shown in Fig. 1, in some embodiments, surfaces of the second regions 120 are flush with surfaces of the first regions 110.

As such, the first region 110 and the second region 120 can be directly formed on the silicon substrate 101 without other processes such as etching.

### Embodiment VIII

As shown in Fig. 3, in some embodiments, a distance between the surfaces of the second regions 120 and a bottom of the groove 130 is less than a distance between the surfaces of the first regions 110 and the bottom of the groove 130.

As such, when the second polarity doped layer 105 is an N-type doped layer, when the cell is transported in a production process, the surface of the cell comes into contact with components such as a belt and a roller, which will cause scratches on the surface. An etching rate of the N-type surface by an alkaline solution is higher than an etching rate of the P-type surface. Therefore, the scratches on the N-type surface are more likely to be etched away in the alkaline solution, leaking to the failure. Therefore, by recessing the N-type surface, the scratches on the N-type surface in a transport process can be avoided, thereby reducing the failure risk.

### Embodiment IX

As shown in Fig. 2, in some embodiments, the side surface of the groove 130 (that is, a surface connecting the bottom surface of the groove 130 to the surfaces of the first regions 110 and the surfaces of the second regions 120) is an inclined surface. The above-mentioned inclined surface is a surface that is not perpendicular to the bottom surface of the groove 130.

As such, vertical crystal planes exhibit more defects, whereas forming the inclined side surface reduces the defect states on the surface of the groove 130. Forming the inclined surface can reduce the surface recombination, thereby reducing the performance of the cell.

### Embodiment X

On the basis of the above-mentioned embodiment 1, a surface 130 of the second extension portion 1051 facing the groove 130 has a concave-convex structure.

As such, by providing the concave-convex texture structure on the surface, the reflection of incident light entering the silicon substrate 101 can be increased, thereby increasing the amount of light absorbed by the cell and improving the conversion efficiency of the cell.

### Embodiment XI

On the basis of the above-mentioned embodiment 1, a roughness of the bottom surface of the groove 130 is greater than a roughness of the side surface of the groove 130, and the roughness of the side surface of the groove 130 is greater than a roughness of surfaces of the first extension portion 1031 and the second extension portion 1051 away from the surface of the groove 130.

As such, by providing texture structures with different roughness levels, the wettability of local regions can be improved, thereby improving the cleaning effect when the cell piece is cleaned.

Furthermore, in some embodiments, the surface of the silicon wafer, which is positioned between the second polarity doped layer 105 and the edge of the groove 130, is a polished surface, and the roughness of the surface of the extension portion facing the groove 130 is greater than the roughness of the surface of the silicon wafer, which is positioned between the second polarity doped layer 105 and the edge of the groove 130.

### Embodiment XII

Further, in some embodiments, a width of the groove 130 ranges from 2µm to 200µm.

As such, setting the width of the groove 130 within such a reasonable range can prevent the width of the groove 130 from being too small to isolate the first polarity doped layer 103 from the second polarity doped layer 105, and can prevent the width of the groove 130 from being too large to make an ineffective area of the back-contact solar cell 100 be excessively large.

Particularly, in such embodiments, the width of the groove 130 may be 2µm, 4µm, 6µm, 8µm, 10µm, 20µm, 40µm, 60µm, 70µm, 100µm, 110µm, 140µm, 160µm, 170µm, 180µm or any value between 2µm and 200µm, which is not particularly limited here.

### Embodiment XIII

In some embodiments, a recess depth of the groove 130 ranges from 0.2µm to 10µm.

As such, setting the recess depth of the groove 130 within such a reasonable range may prevent the length of the groove 130 from being too small to effectively provide isolation, while also avoiding excessive depth that would significantly reduce the strength of the silicon substrate 101 at the groove 130 and decrease the risk of the breakage of the wafer during the fabrication of the back-contact solar cell 100. In other words, excessive depth of the groove 130 results in a thinner region at the groove 130, causing the back-contact solar cell 100 to have insufficient strength at the groove 130 and increasing the susceptibility to the breakage of the wafer.

Particularly, in such embodiments, the recess depth of the groove 130 may be 0.2µm, 0.4µm, 0.6µm, 0.8µm, 1µm, 2µm, 3µm, 4µm, 5µm, 6µm, 7µm, 8µm, 9µm, 10µm or any value between 0.2µm and 10µm, which is not particularly limited here.

### Embodiment XIV

This embodiment provides a cell module including the back-contact solar cell in the above-mentioned embodiments.

The cell module may further include a metal frame, a back sheet, photovoltaic glass and an adhesive film (not shown in the figures). The adhesive film can be filled between a front side 11 of the back-contact solar cell 100 and the photovoltaic glass, the rear side and the back sheet, as well as adjacent cell pieces. As a filler, the adhesive film can be a transparent colloid with good transmittance performance and aging resistance. For example, the adhesive film can use an EVA adhesive film or a POE adhesive film, which can be specifically selected according to actual situations, and is not limited herein.

The photovoltaic glass can cover the adhesive film on the front side 11 of the back-contact solar cell 100. The photovoltaic glass can be ultra-clear glass which has high transmittance, high transparency, and excellent physical, mechanical and optical properties. For example, the transmittance of the ultra-clear glass can reach more than 92%, such that the ultra-clear glass can protect the back-contact solar cell 100 without affecting the efficiency of the back-contact solar cell 100 as much as possible. Moreover, the adhesive film can bond the photovoltaic glass and the back-contact solar cell 100 together, and the adhesive film can be used to seal, insulate and protect the back-contact solar cell 100 from being influenced by water or moisture.

The back sheet can be attached to the adhesive film on the rear side of the back-contact solar cell 100. The back sheet can protect and support the back-contact solar cell 100, and has reliable insulation, water resistance and aging resistance. The back sheet can have various options, and generally can be tempered glass, organic glass, an aluminum alloy TPT composite adhesive film, etc., which can particularly be designed according to specific situations, and is not limited here. An assembly composed of the back sheet, the back-contact solar cell 100, the adhesive film and the photovoltaic glass can be arranged on the metal frame. The metal frame, as a main external support structure of the entire cell module can perform stable support and installation on the cell module. For example, the cell module can be installed at a required position through the metal frame.

The beneficial effects of the cell module of this embodiment are similar to those of the back-contact solar cell 100, and will be omitted here.

### Embodiment XV

This embodiment provides a photovoltaic system including the cell module in the above-mentioned embodiments.

The photovoltaic system can be applied to a photovoltaic power station such as a surface power station, a rooftop power station, a water surface power station, and the like, or can further be applied to equipment or a device that uses solar energy for power generation, such as a user solar power supply, a solar street lamp, a solar car and a solar building. Definitely, it can be understood that, application scenarios of the photovoltaic system are not limited thereto, that is, the photovoltaic system can be used in all fields where solar energy is required for power generation. By using a photovoltaic power generation system network as an example, the photovoltaic system can include a photovoltaic array, a combiner box and an inverter. The photovoltaic array can be an array combination of a plurality of cell modules. For example, the plurality of cell modules can constitute a plurality of photovoltaic arrays. The photovoltaic arrays are connected to the combiner box. The combiner box can converge electric currents generated by the photovoltaic array, and the converged electric currents are converted into alternating currents required by a municipal power grid by passing through the inverter, and then connected to the municipal power grid, so as to realize solar power supply.

The beneficial effects of the photovoltaic system of this embodiment are equivalent to those of the cell module, and will be omitted here.

The above embodiments are preferred embodiments of the present disclosure, and are not intended to limit the present disclosure. Any modifications, equivalent substitutions or improvements made within the spirit and principles of the present disclosure should be included within the scope of protection of the present disclosure.

## Claims

1. A back-contact solar cell, comprising:
a silicon substrate having a rear side and a light-receiving surface arranged opposite to the rear side, wherein first regions and second regions are alternatively arranged on the rear side of the silicon substrate, and a groove is disposed between a first region and a second region adjacent to the first region;
a first tunnelling layer stacked on and covering the first region;
a first polarity doped layer stacked on the first tunnelling layer and having a first extension portion extending toward the groove;
a second tunnelling layer stacked on the second region;
a second polarity doped layer stacked on the second tunnelling layer, wherein a side surface of the second polarity doped layer is spaced apart from a side wall of the groove by a first distance, a second extension portion extends from one side of the second polarity doped layer away from the silicon substrate toward the groove; and
a passivation coating covering the first polarity doped layer, the second polarity doped layer and the groove.

2. The back-contact solar cell according to claim 1, wherein the second extension portion does not extend to a position above the groove.

3. The back-contact solar cell according to claim 1, wherein the passivation coating enwraps the second extension portion.

4. The back-contact solar cell according to claim 3, wherein a side wall of the second tunnelling layer is flush with a side wall of the second polarity doped layer connected to the second tunnelling layer, the passivation coating covers the silicon substrate, the passivation coating covering a bottom surface of the second extension portion is spaced apart from the passivation coating covering the silicon substrate by a second distance, and the second distance is less than 150nm.

5. The back-contact solar cell according to claim 1, wherein along an arrangement direction of the first regions and the second regions, a length of the first extension portion is greater than a length of the second extension portion.

6. The back-contact solar cell according to claim 1, wherein along an arrangement direction of the first regions and the second regions, the length of the first extension portion ranges from 0.5µm to 3µm.

7. The back-contact solar cell according to claim 1, wherein along an arrangement direction of the first regions and the second regions, the length of the second extension portion is less than or equal to 200nm.

8. The back-contact solar cell according to claim 1, wherein surfaces of the second regions are flush with surfaces of the first regions.

9. The back-contact solar cell according to claim 1, wherein a distance between the surfaces of the second regions and a bottom of the groove is less than a distance between the surfaces of the first regions and the bottom of the groove.

10. The back-contact solar cell according to claim 1, wherein a side surface of the groove is an inclined surface.

11. The back-contact solar cell according to claim 1, wherein a surface of the second extension portion facing the groove has a concave-convex structure.

12. The back-contact solar cell according to claim 1, wherein a roughness of a bottom surface of the groove is greater than a roughness of the side surface of the groove, and the roughness of the side surface of the groove is greater than a roughness of surfaces of the first extension portion and the second extension portion away from the surface of the groove.

13. The back-contact solar cell according to claim 1, wherein a width of the groove ranges from 2µm to 200µm.

14. The back-contact solar cell according to claim 1, wherein a recess depth of the groove ranges from 0.2µm to 10µm.

15. A cell module, comprising a plurality of back-contact solar cells according to any one of claims 1 to 14.

16. A photovoltaic system, comprising the cell module according to claim 15.
